# FASCICULE DE BREVET EUROPEEN

(11) **EP 0 408 457 B1**
(45) Date de publication et mention de la délivrance du brevet: **17.02.1993**
(21) Numéro de dépôt: 90402012.0
(22) Date de dépôt: 12.07.1990
(51) Int. Cl.: H01L 27/02

(54) **Structure de circuit intégré CMOS protégé contre les décharges électrostatiques**
Integrierte CMOS-Schaltungsstruktur, die gegen elektrostatische Entladungen geschützt ist
CMOS integrated circuit structure protected against electrostatic discharges

(30) Priorité: 13.07.1989 FR 8909548
(43) Date de publication de la demande: 16.01.1991
(73) Titulaire: SGS-THOMSON MICROELECTRONICS SA, 94250 Gentilly (FR)
(72) Inventeur: Tailliet, François, F-75116 Paris (FR)
(74) Mandataire: Ballot, Paul Denis Jacques

(56) Documents cités:
- GB-A- 2 173 037
- GB-A- 2 210 197

## Description

L'invention concerne les circuits-intégrés.

Le problème qu'on cherche à résoudre est celui de la protection du circuit contre les décharges électrostatiques qui peuvent détruire certains éléments de circuit.

Ces décharges électrostatiques peuvent résulter tout simplement de la manipulation du composant par un opérateur dont les mains ne sont pas reliées à un potentiel fixe, à la terre par exemple. Les décharges se produisent entre les bornes d'entrée/sortie du composant; elles se répercutent à l'intérieur du circuit intégré par l'intermédiaire des plots métallisés déposés sur le substrat dans lequel est formé le circuit; ces plots sont reliés aux bornes extérieures d'entrée/sortie, en général par des fils conducteurs soudés.

Pour immuniser les circuits intégrés contre les effets destructeurs de ces décharges, on place près des plots métallisés des éléments de circuit spécifiques servant principalement à dévier les courants de décharge électrostatiques pour éviter qu'ils ne circulent dans des éléments plus fragiles.

Ces éléments de protection doivent être aptes à dévier une énergie aussi grande que possible sans être eux-mêmes détruits, et on souhaite malgré cela qu'ils occupent une place aussi réduite que possible. En effet ils sont nécessairement très encombrants et consomment une grande partie de la surface de circuit intégré disponible. On voudrait limiter autant que possible la place qu'ils occupent pour garder de la surface pour le circuit intégré proprement dit.

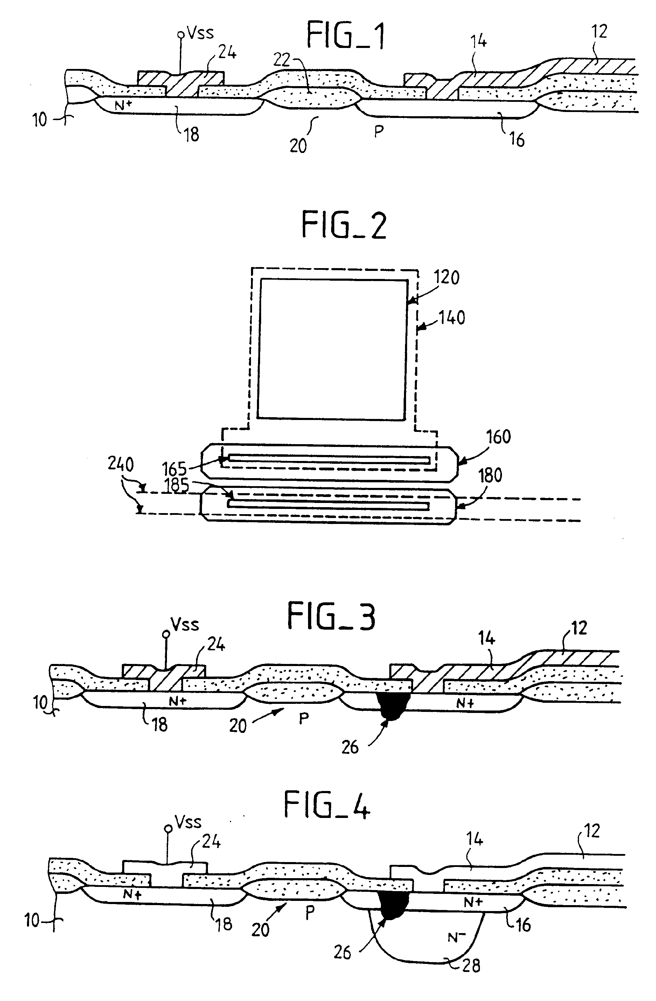

La figure 1 représente un exemple de structure de protection dans le cas d'un circuit intégré réalisé en technologie NMOS, sur substrat de type P. La structure de protection comprend essentiellement un transistor bipolaire latéral de type NPN dont le collecteur est relié à un plot à protéger et l'émetteur à un autre plot ou à un potentiel de référence. La base est constituée par une portion du substrat lui-même.

Sur la figure 1, le substrat de type P est désigné par la référence 10, le plot à protéger par la référence 12; ce plot est relié par une portion de métallisation 14 à une zone 16 de type N+ superficiellement diffusée dans le substrat; cette zone 16 forme le collecteur du transistor de protection NPN latéral. La zone 16 est séparée latéralement d'une autre zone superficielle diffusée de type N+, désignée par 18, constituant l'émetteur du transistor NPN latéral. Une région de base 20, constituée par le substrat de type P lui-même sépare les régions 16 et 18; cette région de base 20 est recouverte d'une couche isolante épaisse 22 (oxyde de silicium). La zone d'émetteur 18 est reliée par un contact métallique 24 par exemple à un potentiel de référence qui est de préférence le potentiel bas d'alimentation Vss du circuit. Le substrat est aussi relié à Vss.

La figure 2 est une vue de dessus montrant la disposition relative du plot à protéger, des zones diffusées et des métallisations. Le contour 120 est le contour du plot métallique 12, tel qu'il apparaît lorsque l'ensemble de la structure est protégée par une couche isolante de passivation non représentée à la figure 1; cette couche recouvre tout le circuit à l'exception de l'ouverture définie par le contour 120. Le contour 140 représente la métallisation reliée au plot 12, y compris le plot 12. Le contour 160 représente la zone diffusée 16 de type N+; le contour 180 représente la zone diffusée 18 de type N+; l'espace étroit entre ces deux contours représente la base 20 du transistor latéral. Le contour 240 représente la métallisation 24 reliée à Vss. Le contour 165 représente l'ouverture de couche isolante par laquelle la métallisation 14 peut venir en contact avec la zone 16. Enfin, le contour 185 représente l'ouverture de couche isolante par laquelle la métallisation 24 peut venir en contact avec la zone diffusée 18.

Lorsque le plot à protéger reçoit des décharges électrostatiques de polarité positive par rapport au substrat, le transistor bipolaire latéral va entrer en conduction par mise en avalanche de sa jonction collecteur base, puis par conduction directe entre collecteur et émetteur.

Lors de décharges de polarité négative la diode constituée par la zone diffusée 16 de type N+ et le substrat de type P va conduire en polarisation directe; le transistor bipolaire latéral pourra en outre se déclencher pour renforcer la conduction.

La limitation des performances de ce type de protection vient souvent de la destruction thermique, à partir d'une certaine énergie, des bords du contact entre la métallisation 14 reliée au plot 12 et la zone diffusée 16. L'échauffement dû au courant de décharge traversant le transistor de protection provoque une migration locale du métal du contact (en général de l'aluminium), allant jusqu'à mettre en court-circuit la jonction N+P située juste en dessous. L'échauffement est maximal sur le bord du contact et c'est à cet endroit qu'il y a destruction de la jonction. Cette jonction n'est qu'à une profondeur très faible de 0,3 à 0,5 micromètre environ.

La figure 3 représente la région de court-circuit 26 créée par cet échauffement.

Le circuit est alors inutilisable puisque le plot à protéger est mis définitivement au potentiel du substrat par ce court-circuit permanent.

En technologie CMOS sur substrat P, on utilise l'opération de diffusion de caissons N- pour créer une zone profonde de type N- juste au dessous du contact entre la métallisation 16 et la région diffusée 16 de type N+. Cela a pour effet de reporter la jonction NP beaucoup plus bas, la profondeur du caisson N- étant plutôt de 4 à 5 micromètres. Même s'il y a échauffement des bords du contact entraînant une fusion localisée du contact au dessous de ces bords, l'aluminium n'atteint pas la profondeur de 4 à 5 micromètres et la jonction d'isolement NP entre le plot et le substrat subsiste intacte.

La figure 4 représente cette disposition. Les références sont les mêmes qu'aux figures précédentes; on y voit le caisson localisé 28 de type N- au dessous du contact. La zone de fusion 26 n'atteint pas la jonction caisson/substrat; le plot n'est pas mis en court-circuit avec le substrat.

De ce fait, les circuits CMOS à substrat P et caisson N peuvent supporter des décharges électrostatiques d'énergie plus importante que les circuits NMOS.

Si on veut transposer cette structure de protection au cas des circuits CMOS sur substrat de type N à caissons de type P, l'idée qui vient naturellement à l'esprit est d'inverser tous les types de conductivité pour réaliser une structure analogue à celle de la figure 4 où toutes les régions P sont remplacées par des régions N et réciproquement. Cela suppose que le transistor NPN latéral est remplacé par un transistor latéral PNP. L'expérience montre que ce type de structure ne fonctionne pas bien, sans doute à cause du temps de réaction plus lent du transistor PNP et de son aptitude limitée à conduire un courant élevé.

L'invention a pour but de proposer une structure de protection pour des circuits CMOS sur substrat N à caissons P, qui soit plus efficace que celles de l'art antérieur.

Selon l'invention, on propose essentiellement de réaliser une structure de protection comprenant un transistor latéral de type NPN formé dans un caisson P, le collecteur du transistor étant relié à une métallisation, l'émetteur étant relié à un plot à protéger, et un contact métallique ohmique étant prévu entre le plot à protéger et le caisson de type P pour le porter au potentiel du plot.

Avec cette structure on obtient des performances améliorées par rapport à celles que permet une protection par transistor PNP latéral.

Cependant, une amélioration supplémentaire très importante peut être obtenue en prévoyant que le collecteur du transistor latéral comprend une région diffusée de type N+ dont une partie est à l'intérieur du caisson P et dont une autre partie est à l'extérieur, le contact entre le collecteur et la métallisation étant effectué dans la partie extérieure.

Le contact est alors éloigné latéralement du bord du caisson et on verra que cela supprime un risque d'endommagement d'une jonction lors d'un passage de courant trop important dans la métallisation de collecteur.

La distance d entre le bord du caisson et les bords de la métallisation de collecteur, là où elle est en contact avec la région N+ de collecteur, est nettement supérieure à la profondeur de la région diffusée N+ de collecteur. De préférence elle est de plusieurs fois cette profondeur; par exemple la distance est de l'ordre de la profondeur du caisson de type P.

Les régions diffusées de type N+ servant d'émetteur et de collecteur seront réalisées en même temps que les régions de source et drain des transistors MOS à canal N réalisés sur le circuit intégré de technologie CMOS.

Le contact ohmique entre le plot à protéger et le caisson sera réalisé par une diffusion de type P+ réalisée en même temps que les régions de source et drain des transistors à canal P du circuit.

D'autres caractéristiques et avantages de l'invention apparaîtront à la lecture de la description détaillée qui suit et qui est faite en référence aux dessins annexés dans lesquels :
- les figures 1 à 4, déjà décrites, et les figures 5 et 6 représentent des structures de protection utilisées dans la technique antérieure;
- la figure 7 représente en coupe une structure selon un réalisation de l'invention;
- la figure 8 représente une vue de dessus correspondant à la figure 7.

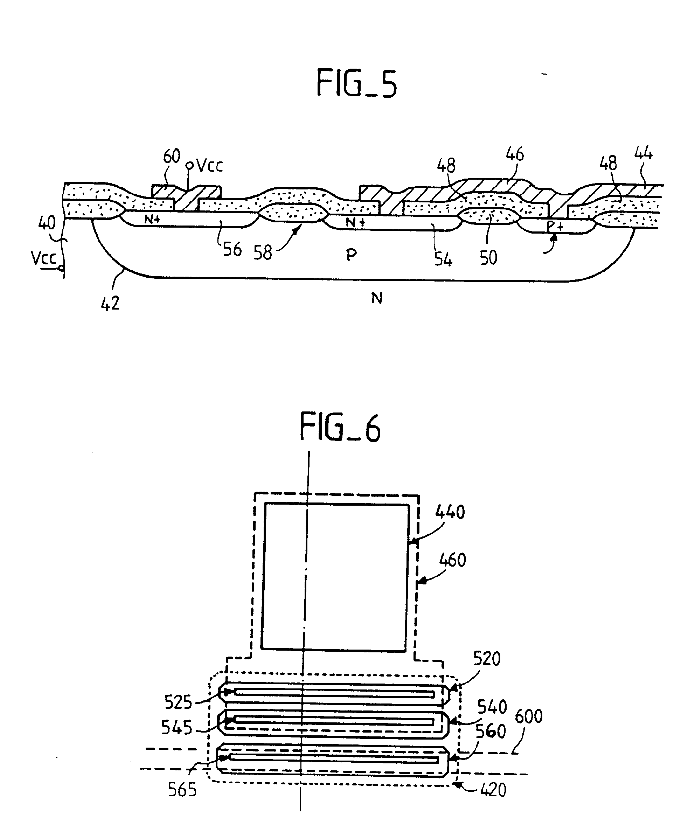

Une structure du type présenté dans les figures 5 et 6 et le préambule de la revendication 1 est décrite dans GB-A-2210197.

Le substrat de type N de la figure 5 est destiné à supporter des circuits réalisés en technologie CMOS, avec des transistors à canal P (non représentés) formés directement dans le substrat et des transistors à canal N (non représentés) formés dans des caissons de type P diffusés dans le substrat.

On utilise un de ces caissons pour former une structure de protection d'un plot contre les décharges électrostatiques appliquées à ce plot.

Le substrat de type N est désigné par la référence 40, le caisson de type P par la référence 42, le plot à protéger par la référence 44.

Le plot est relié à une métallisation superficielle 46 isolée du substrat à la fois par une couche isolante déposée 48 et à certains endroits par une couche isolante 50 (généralement appelée oxyde de champ) formée par croissance thermique lors de la définition des zones actives du circuit intégré.

La métallisation superficielle 46 vient en contact localement avec deux régions superficielles dopées dans le caisson 42. Ces deux régions sont des zones actives du substrat séparées par une portion d'oxyde de champ 50. La première région superficielle est une région 52 dopée de type P+, c'est-à-dire de même type de conductivité que le caisson mais plus fortement dopée. La deuxième région est une région de type N+ 54.

La région 54 constitue l'émetteur d'un transistor bipolaire latéral de type NPN.

La structure comporte une autre région dopée de type N+, 56, séparée de la région 54 par un intervalle étroit qui est en principe recouvert d'oxyde de champ 50. Cet intervalle étroit 58 a comme type de dopage superficiel le dopage original du caisson, c'est-à-dire P. Il constitue la base du transistor latéral NPN; la région de type N+ 56 constitue le collecteur de ce transistor. Bien qu'en principe les régions actives soient celles qui ne sont pas recouvertes d'oxyde de champ 50, la région de base 58 doit ici être considérée comme une région active de la structure.

La région de collecteur est contenue dans le caisson de type P. Elle est recouverte d'une métallisation 60 qui est de préférence reliée au potentiel d'alimentation haut Vcc du circuit. Le substrat de type N est aussi relié au potentiel d'alimentation haut Vcc.

La figure 6 représente une vue de dessus correspondant à la figure 5. On y voit les contours des différentes diffusions et métallisations définies à propos de la figure 5.

Le contour 440 représente le contour du plot à protéger 44, tel qu'il apparaît à travers une fenêtre ouverte dans une couche de passivation non représentée recouvrant l'ensemble du circuit intégré. Le contour 440 est en fait le contour de cette fenêtre.

Le contour 460 est le contour de la métallisation 46 reliée à ce plot et incluant ce plot.

Le contour 420 est le contour du caisson 42. Il est situé au dessous de certaines parties de la métallisation 46 puisque cette métallisation vient contacter des zones diffusées à l'intérieur du caisson, mais en principe il n'est pas situé au dessous du plot à protéger.

Le contour 520 est le contour de la région diffusée de type P+ 52; le contour 525 est le contour d'une ouverture de la couche isolante 48, à travers laquelle la métallisation 46 peut venir en contact avec la région de type P+ 52.

Le contour 540 est celui de la région d'émetteur 54 de type N+ diffusée dans le caisson, et le contour 545 est celui d'une ouverture dans la couche isolante 48, à travers laquelle la métallisation 46 vient en contact avec la région d'émetteur.

De même, le contour 560 est celui de la région de collecteur 56, et le contour 565 est celui de la fenêtre à travers laquelle la métallisation 60 reliée à Vcc vient en contact avec la région de collecteur.

Enfin, le contour 600 est celui d'une ligne de métallisation connectée au potentiel Vcc comme le substrat.

Les diffusions 54 et 56 de type N+ seront réalisées comme si ces régions étaient des régions de drain ou de source de transistors MOS à canal N du circuit intégré. La diffusion de type P+ 52 sera réalisée comme si elle était une diffusion de source ou drain d'un transistor MOS à canal P du circuit.

Lors de décharges électrostatiques positives sur le plot à protéger, la jonction PN entre le caisson P et le substrat N va conduire en polarisation directe. Il peut aussi se produire une conduction du transistor bipolaire latéral NPN. Le plot est protégé par la structure et les charges sont évacuées vers le substrat d'une part et vers la métallisation 60 d'autre part.

Lors de décharges électrostatiques négatives sur le plot à protéger, par rapport au substrat, la jonction collecteur base du transistor bipolaire latéral NPN va se mettre en avalanche et déclencher la conduction du transistor. Les charges sont évacuées par la métallisation 60. La structure fonctionne, mieux que si elle comportait un transistor bipolaire de type PNP, c'est-à-dire qu'elle peut évacuer une plus grande quantité d'énergie.

Toutefois, on s'est rendu compte que pour des quantités de courant importantes à évacuer, il subsistait un risque de destruction localisée a l'endroit où la densité de courant est la plus importante. Il se trouve que cet endroit est en général situé sous les bords de la métallisation 60, et comme la jonction N+P est peu profonde à cet endroit, on risque de la mettre en court-circuit définitif par diffusion du métal du contact dans le semiconducteur. Ce court-circuit porte le plot à protéger au potentiel Vcc de la métallisation, rendant le circuit intégré définitivement inutilisable.

Cependant, on ne peut pas facilement, comme on l'avait fait à la figure 4 pour des substrats de type P, repousser la jonction plus bas à l'aide d'un caisson supplémentaire; on ne dispose pas dans la technologie CMOS d'une étape de diffusion d'un caisson N de profondeur intermédiaire entre celle des diffusions de source et drain N+ et celle du caisson P .

L'invention propose une structure très simple pour repousser le risque de court-circuit de la jonction d'isolement entre le conducteur 60 et le plot à protéger.

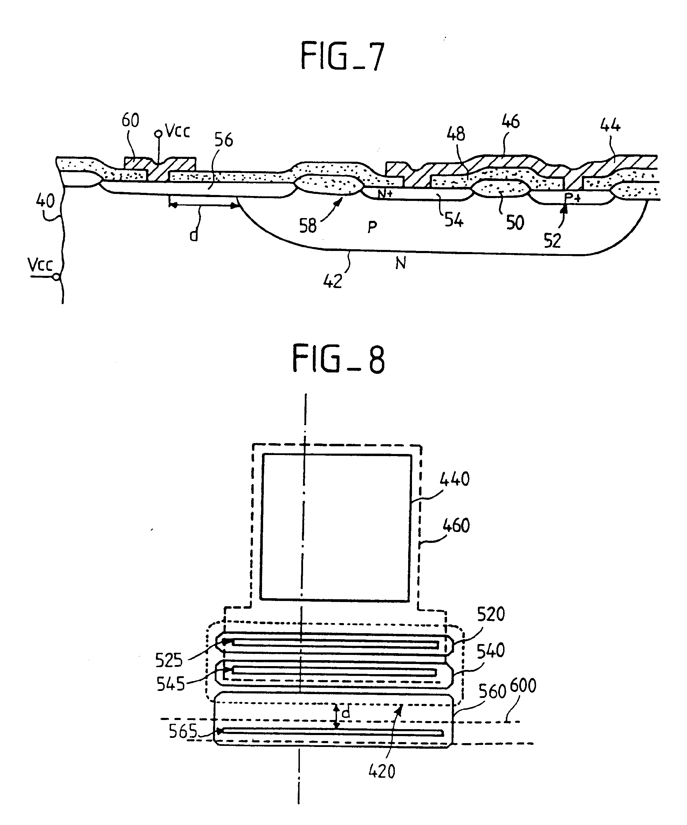

Cette structure est représentée en coupe à la figure 7 et en vue de dessus à la figure 8.

Au lieu que le caisson 42 de type P enferme intégralement la région de collecteur 56, il n'en enferme qu'une partie, celle qui est adjacente à la région de base 58, mais il n'enferme pas la partie de région de collecteur 56 qui vient en contact avec la métallisation 60. Le contact est éloigné latéralement du bord du caisson.

Il en résulte que les bords de la métallisation 60, là où elle est en contact avec la région dopée de type N+ sont situés au dessus d'une région de type N+ qui elle même est située au dessus du substrat de type N et non d'une zone de type P.

Les bords de la métallisation 60 ne surplombent donc pas une jonction NP peu profonde, ni même une jonction NP profonde; ils ne surplombent qu'une transition entre deux zones de même type N, différemment dopées et au même potentiel (Vcc en principe).

Par conséquent, même si les décharges négatives sur le plot 44 aboutissaient à une densité de courant telle qu'il y ait fusion localisée et migration d'aluminium sous les bords de la métallisation 60, il n'en résultera pas de mise en court-circuit de la jonction caisson/substrat qui assure normalement l'isolement entre le plot 44 à protéger et le potentiel Vcc.

La région diffusée 52 de type P+ reste bien entendu à l'intérieur du caisson 42 puisqu'elle sert à établir un contact ohmique pour mettre le caisson au potentiel du plot 44.

La région diffusée 54 d'émetteur reste aussi à l'intérieur du caisson pour permettre de former un transistor latéral à l'intérieur du caisson avec la partie de région de collecteur 56 qui subsiste à l'intérieur du caisson.

La distance entre le bord de la métallisation 60, là où elle est en contact avec la région de collecteur 56, et le bord du caisson doit être suffisante pour qu'il n'y ait pas de risque de court-circuiter la jonction caisson substrat. Cela veut dire en pratique que la distance d entre le bord de la métallisation et le bord du caisson est nettement plus grande que la profondeur de la région 56 (quelques dixièmes de micromètres), par exemple plusieurs fois cette profondeur. Cette distance d peut être de l'ordre de la profondeur du caisson 42 (quelques micromètres).

La figure 8 représente une vue de dessus de la structure de protection de la figure 7, les mêmes références qu'à la figure 5 ont été utilisées; on voit que le contour 420 du caisson 42 est plus petit qu'à la figure 5; il vient partiellement au dessous du contour 560 de la région de collecteur, mais pas complètement; une partie de la région de collecteur 56 est en dehors du caisson, et c'est dans cette partie qu'on trouve le contour 565 du contact entre la métallisation 60 et la région de collecteur. On remarquera sur la figure 8 la distance d entre le contour 565 du contact et le bord du contour du caisson 42.

## Revendications

1. Circuit intégré en technologie CMOS à substrat N (40) et caisson P (42), comportant une structure de protection d'un plot de contact (44) contre les décharges électrostatiques, cette structure de protection comprenant un transistor latéral de type NPN formé dans un caisson P (42), le collecteur (56) du transistor étant relié à une métallisation (60), l'émetteur (54) étant relié à un plot à protéger (44), et un contact métallique ohmique étant prévu entre le plot à protéger et le caisson de type P pour le porter au potentiel du plot, caractérisé en ce que la région de type N+ constituant le collecteur (56) comprend une partie située à l'intérieur du caisson de type P (42) et une partie s'étendant à l'extérieur du caisson, la métallisation (60) venant en contact avec la région de collecteur (56) dans cette partie extérieure.

2. Circuit intégré selon la revendication 1, caractérisé en ce que la base du transistor NPN latéral est constituée par une portion superficielle (58) du caisson, séparant une région dopée de type N+ constituant le collecteur et une région dopée de type N+ constituant l'émetteur.

3. Circuit intégré selon la revendication 2, caractérisé en ce que la distance d entre le bord de la métallisation à l'endroit du contact et le caisson de type P est d'au moins plusieurs fois la profondeur de la région de collecteur ou d'émetteur.

4. Circuit intégré selon la revendication 3, caractérisé en ce que la distance d est de l'ordre de la profondeur du caisson de type P.

5. Circuit intégré selon l'une des revendications précédentes, caractérisé en ce que le substrat et la métallisation en contact avec la région de collecteur sont portés à un potentiel haut d'alimentation du circuit intégré.

6. Circuit intégré selon l'une des revendications précédentes, caractérisé en ce que l'émetteur et le collecteur du transistor latéral NPN sont réalisés par des diffusions identiques à des diffusions de source et drain de transistors MOS à canal N réalisés sur le même substrat.

7. Circuit intégré selon l'une des revendications précédentes, caractérisé en ce que le contact ohmique entre le plot à protéger et le caisson de type P est établi par une diffusion de type P+ identique à des diffusions de source et drain de transistors à canal P réalisés sur le même substrat.

## Patentansprüche

1. Integrierte Schaltung in CMOS-Technologie mit N-Substrat (40) und P-Zone (42), umfassend eine Struktur zum Schutz einer Kontaktanschlußeinrichtung (44) gegen elektrostatische Entladungen, wobei diese Schutzstruktur einen in einer PZone (42) gebildeten lateralen Transistor vom NPN-Typ umfaßt, wobei der Kollektor (56) des Transistors mit einer Metallisierung (60) verbunden ist, wobei der Emitter (54) mit einer zu schützenden Anschlußeinrichtung (44) verbunden ist, und wobei ein metallischer Ohmscher Kontakt zwischen der zu schützenden Anschlußeinrichtung und der Zone vom P-Typ vorgesehen ist, um diese auf das Potential der Anschlußeinrichtung zu bringen, dadurch **gekennzeichnet**, daß der den Kollektor (56) bildende Bereich vom (N+)-Typ einen im Inneren der Zone vom P-Typ (42) liegenden Teil und einen sich außerhalb der Zone erstreckenden Teil umfaßt, wobei die Metallisierung (60) mit dem Bereich des Kollektors (56) in diesem äußeren Teil in Kontakt gelangt.

2. Integrierte Schaltung nach Anspruch 1, dadurch **gekennzeichent,** daß die Basis des lateralen NPN-Transistors durch einen Oberflächenteil (58) der Zone gebildet ist, der einen den Kollektor bildenden, dotierten Bereich vom (N+)-Typ und einen den Emitter bildenden, dotierten Bereich vom (N+)-Typ trennt.

3. Integrierte Schaltung nach Anspruch 2, dadurch **gekennzeichent**, daß der Abstand d zwishen dem Rand der Metallisierung an der Stelle des Kontaktes und der Zone vom P-Typ wenigstens mehrere Male die Tiefe des Kollektor- oder Emitterbereiches ist.

4. Integrierte Schaltung nach Anspruch 3, dadurch **gekennzeichnet**, daß der Abstand d in der Größe von der Tiefe der Zone vom P-Typ ist.

5. Integrierte Schaltung nach einem der vorhergehenden Ansprüche, dadurch **gekennzeichnet**, daß das Substrat und die Metallisierung in Kontakt mit dem Kollektorbereich auf ein hohes Versorgungspotential der integrierten Schaltung gebracht sind.

6. Integrierte Schaltung nach einem der vorhergehenden Ansprüche, dadurch **gekennzeichnet**, daß der Emitter und der kollektor des lateralen NPN-Transistors durch zu Source- und Drain-Diffusionen von auf demselben Substrat ausgeführten N-Kanal-MOS-Transistoren identische Diffusionen ausgeführt sind.

7. Integrierte Schaltung nach einem der vorhergehenden Ansprüche, dadurch **gekennzeichnet**, daß der Ohmsche Kontakt zwischen der zu schützenden Anschlußeinrichtung und der Zone vom P-Typ durch eine Diffusion vom (P+)-Typ identisch mit Source- und Drain-Diffusionen von auf demselben Substrat ausgeführten P-Kanal-Transistoren eingerichtet ist.

## Claims

1. An integrated circuit using CMOS technology with an n substrate (40) and p well (42), including a structure for protection of a contact (44) against electrostatic discharges, this protective structure comprising a lateral npn type transistor formed in a p well (42), the collector (56) of the transistor being connected to a metallic layer (60) and the emitter being connected to a contact (44) to be protected, and a metallic ohmic contact provided between the contact to be protected and the p type well in order to bring it to the potential of the contact to be protected, chracterised in that the n+ type area comprising the collector (56) has one part situated inside the p type well (42) and one part on the outside of the well, the metallic layer (60) making contact with the collector area (56) in this external part.

2. An integrated circuit according to Claim 1, characterised in that the base of the lateral npn transistor is formed from an upper part (58) of the well, separating a doped n+ type area forming the collector and a doped n+ type area forming the emitter.

3. An integrated circuit according to Claim 2, characterised in that the distance d between the edge of the metallisation at the point of contact and the p type well is at least several times the depth of the emitter or collector area.

4. An integrated circuit according to Claim 3, characterised in that the distance d is approximately equal to the depth of the p type well.

5. An integrated circuit according to any one of the preceding Claims, characterised in that the substrate and the metallic layer in contact with the collector area are brought to a high potential of the integrated circuit.

6. An integrated circuit according to any one of the preceding claims, characterised in that the emitter and the collector of the lateral npn transistor are created by means of diffusions identical to source and drain diffusions of n-channel MOS transistors created on the same substrate.

7. Integrated circuit according to any one of the preceding claims, characterised in that the ohmic contact between the contact to be protected and the p type well is created by a p+ type diffusion identical to source and drain diffusions of p channel transistors created on the same substrate.
